# EUROPÄISCHE PATENTANMELDUNG

(11) **EP 3 993 580 A1**
(43) Veröffentlichungstag der Anmeldung: **04.05.2022**
(21) Anmeldenummer: 21202871.6
(22) Anmeldetag: 15.10.2021
(51) Int. Cl.: H05K 5/00, H05K 5/06, B60R 11/02, B60R 16/023

(54) **ABBIEGEASSISTENZSYSTEMS EINES FAHRZEUGS UMFASSEND EIN ELEKTRONIKGEHÄUSE**

(30) Priorität: 27.10.2020 DE 202020106127 U
(71) Anmelder: KNORR-BREMSE Systeme für Nutzfahrzeuge GmbH, 80809 München (DE)
(72) Erfinder: SCHMIEDT, Stefan, 82387 Antdorf (DE); STEHLIK, Ladislav, 46303 Straz nad Nisou (CZ); MACKE, Wlodzimierz, 82140 Olching (DE)

(57) **Zusammenfassung**

Ein Abbiegeassistenzsystem (100) eines Fahrzeugs (200) umfassend ein Elektronikgehäuse (1) umfassend ein Gehäuseunterteil (3) für die Anordnung einer oder mehrerer Elektronikkomponenten des Abbiegeassistenzsystems (100) und einen Deckel (2) zum Verschluss des Innenraums des Elektronikgehäuses (1), wobei das Elektronikgehäuse (1) eine umlaufende Labyrinthdichtung (7) zwischen dem Deckel (2) und dem Gehäuseunterteils (3) aufweist.

## Beschreibung

Die vorliegende Erfindung betrifft ein Abbiegeassistenzsystem eines Fahrzeugs mit einem Elektronikgehäuse nach dem Oberbegriff des Anspruchse 1.

Eine bereits seit längerem bekannte Unfallquelle im Straßenverkehr sind Passanten, Fahrradfahrer oder andere Verkehrsteilnehmer. Insbesondere links des Fahrzeugs, z.B. eines LKWs, kommt es häufig zu einem sehr dichten Annähern von Verkehrsteilnehmern an das Fahrzeug, wobei sich diese Verkehrsteilnehmer dann im toten Winkel befinden. Biegt das Fahrzeug sodann nach links ab, kann es zu schwerwiegenden Unfällen kommen.

Abbiegeassistenzsysteme schützen daher vor Unfällen. Bekannte Abbiegeassistenzsysteme können auf optischen oder akustischen Signalen beruhen. Gelegentlich werden auch Kameras eingesetzt. Die hierfür bevorzugt eingesetzten Kameras sind Weitwinkelkameras, welche dem Fahrzeugführer einen optimalen Überblick über das Geschehen im toten Winkel des Fahrzeugs geben.

Diese Kameras benötigen allerdings viel Leistung, z.B. etwa 20 Watt oder mehr. Die Kammerasignale sollten idealerweise in Echtzeit analysiert und ausgewertet werden, da es im Verkehr auf Sekundenbruchteile ankommt. Entsprechend ist die Wärmeentwicklung der Elektronikbauteile des Abbiegeassistenzsystems, welche die Auswertung übernehmen, deutlich höher als bei herkömmlichen Elektronikbauteilen und eine entsprechende Wärmeabführung sollte gewährleistet werden.

Ein Elektronikgehäuse empfiehlt sich abgesetzt von den Sensorelementen, z.B. der Kamera oder den Kameras, am Fahrzeug zu montieren, da die Sensorelemente möglichst wenig aus dem Fahrzeug hervorstehen sollten und die Elektronik zugleich einen erhöhten Bedarf an Bauraum aufweist.

Zugleich ist die Umgebung des Fahrzeugs nicht vergleichbar mit einer herkommlichen Umgebung z.B. eines Heim-PC's. Eine Fahrzeug kann vibrieren, es unterliegt Erschütterungen, weiterhin sind Regen, Hitze und Staub zu beachten. Dies ist bei der Konzipierung eines geeigneten Elektronikgehäuses und dessen Positionierung zu berücksichtigen.

Die DE 10 2016 006 978 B4 offenbart ein Elektronikgehäuse für ein Messgerät, welches einen vollständig gekapselten Gehäuseinnenraum aufweist. Zur Kapselung wird ein aushärtbares Dichtmittel eingesetzt, welches das Gehäuseoberteil und das Gehäuseunterteil im ausgehärteten betriebsbereiten Zustand unlösbar miteinander verbindet.

Unter Berücksichtigung aller vorgenannten Kriterien ist es daher die Aufgabe der vorliegenden Erfindung ein Elektronikgehäuse bereitzustellen, welches sich für das Einsatzgebiet eines Abbiegeassistenzsystems besonders gut eignet und die Ausfallwahrscheinlichkeit der Elektronikbausteine minimiert.

Die vorliegende Erfindung löst diese Aufgabe durch ein Abbiegeassistenzsystems mit den Merkmalen des Anspruchs 1..

Ein erfindungsgemäßes Abbiegeassistenzsystem eines Fahrzeugs umfasst ein Elektronikgehäuse mit einem Gehäuseunterteil für die Anordnung einer oder mehrerer Elektronikkomponenten des Abbiegeassistenzsystems und einen Deckel zum Verschluss des Innenraums des Elektronikgehäuses.

Das Elektronikgehäuse weist zur Vermeidung von Feuchtigkeit und/oder Staub, welche in der vorgenannten Anwendung im erhöhten Maße auftritt, eine umlaufende Labyrinthdichtung zwischen dem Deckel und dem Gehäuseunterteils auf.

Durch die Labyrinthdichtung kann eine Abdichtung auf eine unkomplizierte Art und Weise erreicht werden, wobei die Elektronikbauteile zu Wartungs- und/oder Reparaturzwecken auch problemlos zugänglich sind.

Elektronikbauteile sind in diesem Kontext zumindest eine Steuer und/oder Auswerteeinheit des besagten Abbiegeassistenzsystems, vorzugsweise umfassend eine oder mehrere Datenspeicher, Recheneineinheiten und/oder Steuerschaltungen.

Die Labyrinthdichtung kann vorzugsweise unter Verwendung von Dichtungen auf Basis von Silikonen oder von Flüssigdichtungen konzipiert, bzw. gefüllt sein. Die Silikone oder Flüssigdichtungen sind dabei durch fließfähige Stoffe, also insbesondere durch Flüssigkeiten oder Pasten gebildet, welche auch im betriebsbereiten Zustand des Elektronikgehäuses fließfähig bleiben. Ein betriebsbereiter Zustand des Elektronikgehäuses liegt vor, wenn es im erfindungsgemäßen Abbiegeassistenzsystem integriert ist. Insgesamt ist die Dichtung bzw. das Dichtmittel fließfähig und nicht aushärtbar, insbesondere auch nicht über längeren Gebrauch hinweg. Nicht aushärtbar bedeutet in diesem Kontext, dass das Dichtmittel zwar alterungsbedingt seine Viskosität verändern kann, allerdings fließfähig bleibt.

Weitere vorteilhafte Ausgestaltungen der Erfindung sind Gegenstand der Unteransprüche sowie der übrigen Beschreibung.

Vorzugsweise ist der Deckel des Elektronikgehäuses durch Lösen von mechanischen Mitteln, so z.B. Schrauben, vom Gehäuseunterteil abnehmbar ausgebildet. Hierfür kann besonders bevorzugt ein Schlitz am Außenumfang zwischen dem Deckel und dem Gehäuseunterteil ausgebildet, so dass der Deckel mittels eines Schraubenziehers aufgehebelt werden kann.

Ergänzend zur Labyrinthdichtung kann das das Elektronikgehäuse eine randseitige Leitungsführung mit Leitungskanälen zur Anordnung von Signalleitungen und/oder Energieleitungen aufweisen. Die Aus- und/oder Eingänge für Kabel in das Elektronikgehäuse sollten dicht ausgebildet sein und zugleich sollten die Kabel eine gewisse Beweglichkeit aufweisen.

Die Labyrinthdichtung kann zumindest eine Nut und einen in die Nut hineinragenden umlaufenden Vorsprung aufweisen, wobei zwischen der Nut und dem Vorsprung ein Freiraum zur Aufnahme eines Dichtmittels, insbesondere eines flüssigen Dichtmediums, angeordnet ist. Dieser Freiraum kann zugleich als Toleranzausgleich dienen.

Die Labyrinthdichtung kann randseitig, insbesondere in Richtung der Außenseite des Elektronikgehäuses, eine Dichtfläche aufweisen, entlang welcher der Deckel und das Gehäuseunterteil aneinander anliegen. Da sich bei der Montage des Deckels noch Fremdmaterial, z.B. Staub usw., zwischen den Dichtflächen des Deckels und des Gehäuseunterteils angeordnet sein kann, wird eine Dichtfläche ohne weitere Dichtmittel für die Umgebungsbedingungen als nicht hinreichend angesehen. Allerdings ermöglicht die Dichtfläche eine erste Abdichtungsbarriere, während die Labyrinthdichtung mit dem Dichtmittel die zweite Abdichtungsebene darstellt.

Die Labyrithdichtung kann randseitig, insbesondere in Richtung des Innenraumes des Elektronikgehäuses, einen umlaufenden Schlitz als Ausgleichsbereich für das Dichtmittel aufweist. Beispielsweise kann ein flüssiges Dichtmittel in den Schlitz laufen, welches beim Verschluss in den Schlitz gepresst wird.

Die Leitungskanäle können zumindest eine oder mehrere nutförmige Kanalerweiterungen, insbesondere nutförmige Ausfräsungen, vorzugsweise zur Aufnahme von Dichtmittel, aufweisen. Die Kanalerweiterungen ermöglichen in besonders vorteilhafter Art und Weise die Abdichtung der Leitungen und ermöglichen zugleich die Beweglichkeit der Leitungen. Die Kanalerweiterung kann vorzugsweise linear ausgebildet sein und schräg, insbesondere senkrecht zur Erstreckungsrichtung der Leitungskanäle angeordnet sein.

Die Labyrithdichtung und/oder die Kanalerweiterungen sind vorzugsweise mit dem Dichtmittel versehen, wobei das Dichtmittel ein flüssiges Dichtmittel und/oder ein Dichtmittel auf Silikonbasis ist. Somit ist das Dichtmittel in dieser Ausführungsvariante ein Teil des Elektronikgehäuses.

Die Leitungsführung kann eine Leitungsauflage und eine Leitungsabdeckung umfassen, wobei die Leitungsauflage und/oder die Leitungsabdeckung jeweils zumindest einen oder mehreren Leitungskanal und pro Leitungskanal jeweils eine, vorzugsweise zwei, nacheinander angeordnete Kanalerweiterungen aufweisen. Somit weist auch die Leitungsführung zwei Abdichtungsebenen auf.

Die Leitungsauflage und die Leitungsabdeckung können aufeinander in Wesentlichen auf der gleichen Ebene wie die Dichtfläche aufliegen.

Weiterhin kann das vorbeschriebene Abbiegeassistenzsystem ein Elektronikgehäuse mit Temperaturleitrippen aufweisen.Vorteilhaft ist das Elektronikgehäuse dabei zur Optimierung der Temperaturableitung durch die Temperaturleitrippen als ein Aluminiumgehäuse ausgebildet.

Das Elekronikgehäuse weist vorteilhaft zumindest eine bodenseitige Auswölbung auf, entlang welcher die Temperaturleitrippen außenseitig angeordnet sind. Die Elektronikbauteile liegen an den besagten bodenseitigen Auswölbungen flächig, insbesondere mit Hilfe von Wärmeleitpaste, an und die Wärme wird über die Wandung der Auswölbung und die Temperaturleitrippen abgegeben.

Bevorzugt weisen einzelne oder alle Temperaturleitrippen eine durchschnittliche Höhe von zumindest 5 mm, vorzugsweise zumindest 8 mm, auf und eine Beabstandung voneinander zwischen 50-150% ihrer Höhe.

Das Elektronikgehäuse kann zwei bodenseitige Auswölbungen aufweisen und ein zwsichen den Auswölbungen angeordneter Steg, zur Beabstandung zweier Elektronikkomponenten. Sofern ein Elektronikbaustein aufgrund von Erwärmung ausfällt, kann der zweite Elektronikbaustein noch weiterarbeiten und einen Notbetrieb gewährleisten. Dies wird durch eine teilweise Entkopplung der Wärmeleitung durch den Steg ermöglicht.

Das Elektronikgehäuse, insbesondere der Steg, kann vorteilhaft ein Druckausgleichsventil aufweisen.

Das Elektronikgehäuse weist zumindest ein Elektronikbauteil auf, welches vermittels einer Wärmeleitpaste an der Innenseite der Auswölbungen angeordnet ist.

Weiterhin vorteilhaft kann das Abbiegeassistenzsystem eines oder mehrere Sensorelemente, vorzugsweise zumindest eine Kamera, besonders bevorzugt zumindest eine Weitwinkelkamera, aufweisen, welche außerhalb des Elektronikgehäuses, insbesondere außerhalb des Fahrzeugs, angeordent sind.

Weiterhin erfindungsgemäß ist ein Fahrzeug mit dem erfindungsgemäßen Abbiegeassistenzsystem.

Weitere Vorteile, Merkmale und Einzelheiten der Erfindung ergeben sich aus der nachfolgenden Beschreibung, in ein Ausführungsbeispiel der Erfindung anhand der beiliegenden Zeichnung näher erläutert werden. Der Fachmann wird die in der Zeichnung, der Beschreibung und den Ansprüchen in Kombination offenbarten Merkmale zweckmäßigerweise auch einzeln betrachten und zu sinnvollen weiteren Kombinationen zusammenfassen. Es zeigen:
- Fig. 1: eine erste Seitenansicht einer ersten erfindungsgemäßen Ausführungsvariante eines Elektronikgehäuses eines Abbiegeassistenzsystems;
- Fig. 2: eine Draufsicht auf das Elektronikgehäuse der Fig. 1;
- Fig. 3: eine zweite Seitenansicht des Elektronikgehäuses;
- Fig. 4: eine Detailansicht des Randbereichs des Elektronikgehäuses;
- Fig. 5: eine erste teilgeschnittene Seitenansicht eines Gehäuseunterteils des Elektronikgehäuses;
- Fig. 6: eine Draufsicht auf das Gehäuseunterteil;
- Fig. 7: eine Detailansicht auf eine Leitungsführung im Gehäuseunterteil;
- Fig. 8: Detailansicht des Aufnahmebereichs für Verbindungsmittel;
- Fig. 9: Detailansicht eines Dichtbereichs des Gehäuseunterteils;
- Fig. 10: eine zweite Seitenansicht des Gehäuseunterteils;
- Fig. 11: eine Perspektivansicht des Gehäuseunterteils;
- Fig. 12: eine Detailansicht einer Leitungsführung im Gehäuseunterteil;
- Fig. 13: eine Draufsicht auf einen Deckel des Elektronikgehäuses;
- Fig. 14: eine erste Seitenansicht auf den Deckel;
- Fig. 15: eine zweite Seitenansicht auf den Deckel;
- FIg. 16: eine Perspektivansicht auf den Deckel;
- FIg. 17: eine Detailansicht einer Leitungsführung im Gehäuseunterteil;
- Fig. 18: eine Detailansicht eines Dichtbereich des Deckels;
- Fig. 19: eine Unteransicht des Deckels; und
- Fig. 20: eine schematische Ansicht eines Fahrzeugs mit einem Abbiegeassistenzsystem.

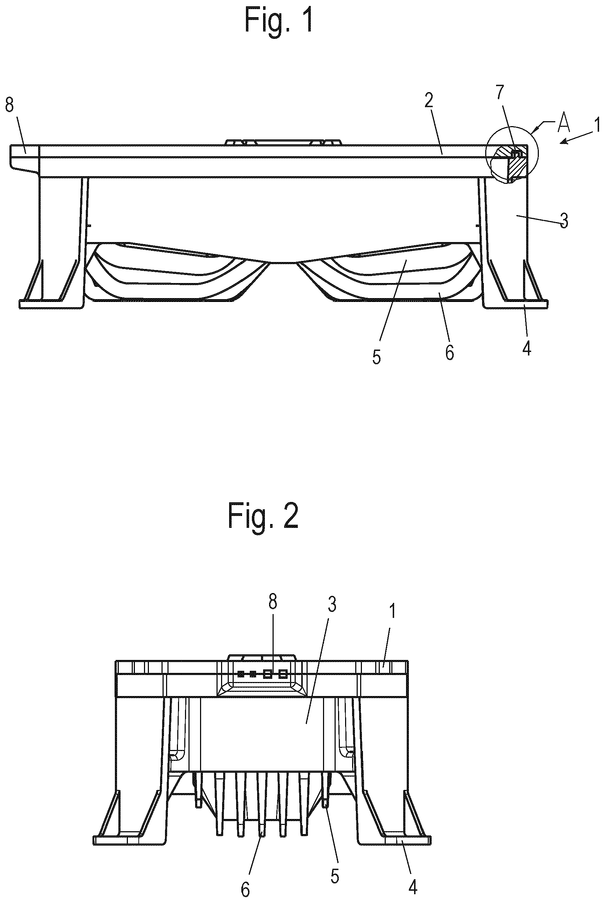

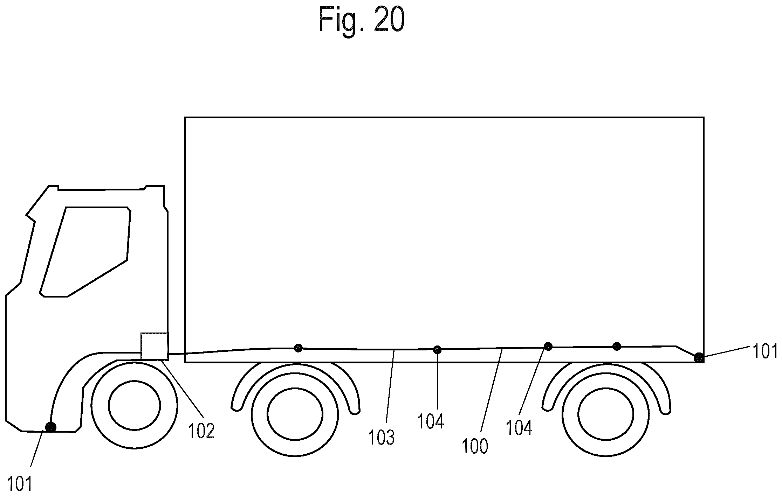

**Fig. 1-4** zeigt ein Elektronikgehäuse 1 für die Elektronikkomponenten eines Abbiegeassistenzsystems 100 eines Fahrzeugs 200. Das Fahrzeug 200 und das zugeordnete Abbiegeassistenzsystem 100 ist in **Fig. 20** dargestellt. Es weist zumindest ein Sensorelement 101 auf, welche bevorzugt als eine Kamera, insbesondere eine Weitwinkelkamera, sein kann.

Das Sensorelement 101, insbesondere die Weitwinkelkamera, kann vorzugsweise durch Signale wie Lenkeinschlag, Geschwindigkeit und/oder Blinker aktiviert werden. Alternativ oder zusätzlich kann einer oder mehrere weitere Sensoren 104, beispielsweise Bewegungssensoren, vorgesehen sein, um die Annäherung von Personen an das Fahrzeug zu überwachen.

Zusätzlich zu der optischen Anzeige durch die Kamera kann eine Anzeige von Hindernissen über eine optische Anzeige, z.B. LEDs, oder über akustische Signale im Fahrerhaus erfolgen.

In **Fig. 20** ist eine erste Kamera am Fahrzeug dargestellt. Selbstverständlich können auch mehrere Kameras, beispielsweise zwei Kameras an beiden Enden des Fahrzeugs, entlang der Beifahrerseite angeordnet sein.

Insgesamt dient das Abbiegeassistenzsystem dazu die Verkehrssicherheit zu erhöhen und Leben durch Warnung des Fahrers und durch Anzeige des toten Winkels zu retten.

Im Fall der vorliegenden Erfindung werden Elektronikkompnenten 102 räumlich abgesetzt von den Sensorelementen 101, zumindest jedoch räumlich abgesetzt von der Kamera, angeordnet. Die Elektronikkomponenten 102 umfassen vorzugsweise eine Auswerte- und/oder Steuereinheit zur Bildbearbeitung und/oder zur Aktivierung und/oder Desaktivierung des Abbiegeassisntenzsystems. Sie können über Signalleitungen 103 mit den Sensorelementen 101 und den weiteren Sensoren 104 verbunden sein.

Derartige Abbiegeassistenzsysteme arbeiten allerdings typischerweise mit einer hohen Leistung. Daher wird durch den Betrieb der Elektronikkomponenten 102 viel Wärme erzeugt, welche abgeführt werden muss. Zugleich muss die empfindliche Elektronik beim vorgenannten Anwendungszweck im erhöhten Maße vor Medien wie Staub geschützt werden. Auch äußere Temperatureinflüsse je nach Anwendungsgebiet, z.B. Wüste, Permafrostgebiete, usw. sind bei der Konzipierung eines Elektronikgehäuses zu berücksichtigen.

Das Elektronikgehäuse 1 der **Fig. 1-4** weist einen Deckel 2 auf und ein Gehäuseunterteil 3. Zwischen dem Deckel 2 und dem Gehäuseunterteil 3 ist eine Dichtung 7 angeordnet, welche als Labyrinthdichtung ausgebildet ist. Diese Labyrithdichtung ist mit einem Dichtmediums, vorzugsweise einem flüssigen Dichtmedium, besonders bevorzugt auf Silikonbasis, gefüllt.

Entlang dem deckelfernen Boden des Gehäuseunterteils 3 sind Temperaturleitrippen 5 und 6 angeordnet, wobei der Boden bauchig ausgebildet ist und wobei die Temperaturleitrippen 5 und 6 entsprechend der Form des Bodens unterschiedlich dimensioniert sind. Die Temperaturleitrippen weisen eine Höhe von zumindest 5%, vorzugsweise zumindest 8 %, gegenübher der Höhe h des Elektronikgehäuses auf.

Weiterhin das Gehäuseunterteil 3 Montagefüße 4 auf, welche aus der Gehäusewandung hervorstehen und welche eine plattenförmige Ausformung und Versteifungen dieser Ausformung aufweisen.

Die Schnittstelle zwischen Deckel 2 und Gehäuseunterteil 3 weist zudem eine Leitungsführung 8, welche der abgedichteten Aus- und Einführung von Signal- und/oder Energieversorgungskabeln in den Innenraum des Elektronikgehäuses dienen. Diese ist besonders gut in **Fig. 2** zu erkennen.

Der Deckel 2 ist mit dem Gehäuseunterteil 3 an Verbindungsstellen 15' durch Verbindungsmittel mechanisch verbunden, insbesondere verschraubt, sind.

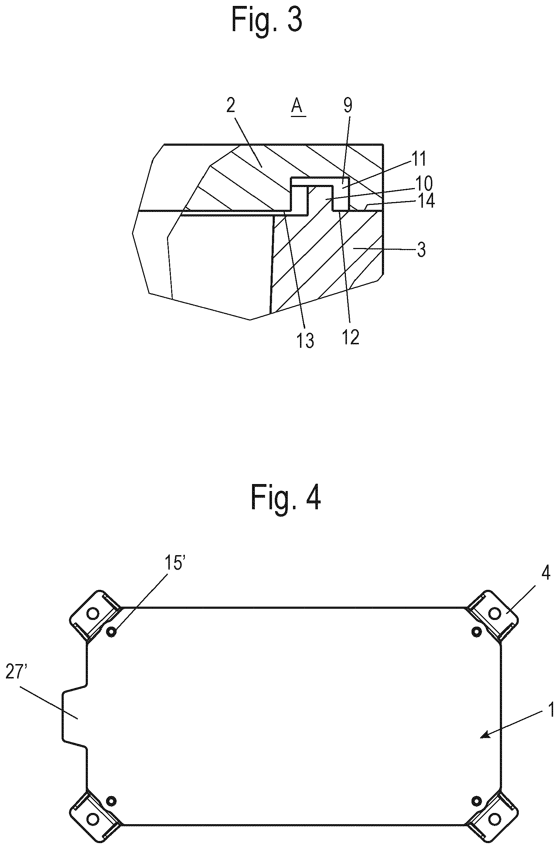

Die Dichtung 7 in der Ausgestaltung als Labyrinthdichtung ist besonders gut aus Fig. 3 erkennbar. Hierbei weist der Deckel 2 eine Nut 9 auf. Der Deckel 2 und das Gehäuseunterteil 3 weisen entlang einer Dichtfläche 14 jeweils eine Auflagefläche 12 auf, wobei die Auflageflächen aneinander anliegen und das Gehäuse somit verschließen.

Das Gehäuseunterteil 3 weist zudem einen Vorsprung 10 auf, welcher aus der Auflagefläche 12 des Gehäuseunterteils hervorsteht und welcher in die Nut 9 hineinragt. Zwischen den Wandungen der Nut 9 und der Oberfläche des Vorsprungs ist ein Freiraum vorgesehen, welcher in der vorliegenden Ausgestaltung ein u-förmiger Freiraum 11 ist. Jenseits der Nut 9 in Richtung der Umgebung des Elektronikgehäuses 1 liegt der Deckel 2 entlang der Dichtfläche 14 auf dem Gehäuseunterteil 3 auf.

Ebenfalls jenseits der Nut 9, allerdings in Richtung eines Innenraumes des Elektronikgehäuses ist der Deckel gegenüber dem Gehäuseunterteil beabstandet, so dass das Dichtmedium aus der Nut 9 zum Druckausgleich in Richtung des Innenraumes entweichen kann. Somit ist zwischen dem Deckel 2 und dem Gehäuseunterteil 3 ein umlaufender Schlitz 13 ausgebildet, welcher in der Nut 9 mündet.

Der Deckel 2 ist als Flachdeckel ausgestaltet. Erweist somit eine Höhe b von weniger als 15%, vorzugsweise weniger als 10%, gegenüber der Höhe h des Gehäuseunterteils 3 auf.

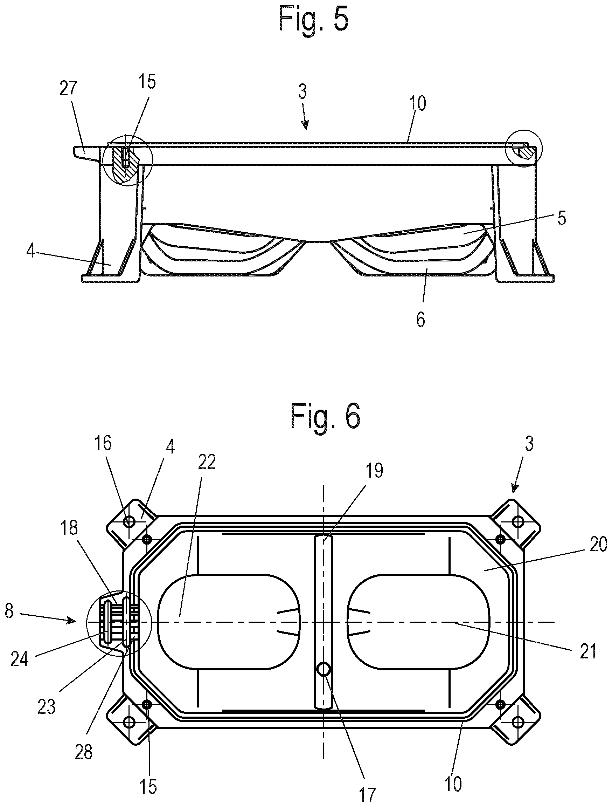

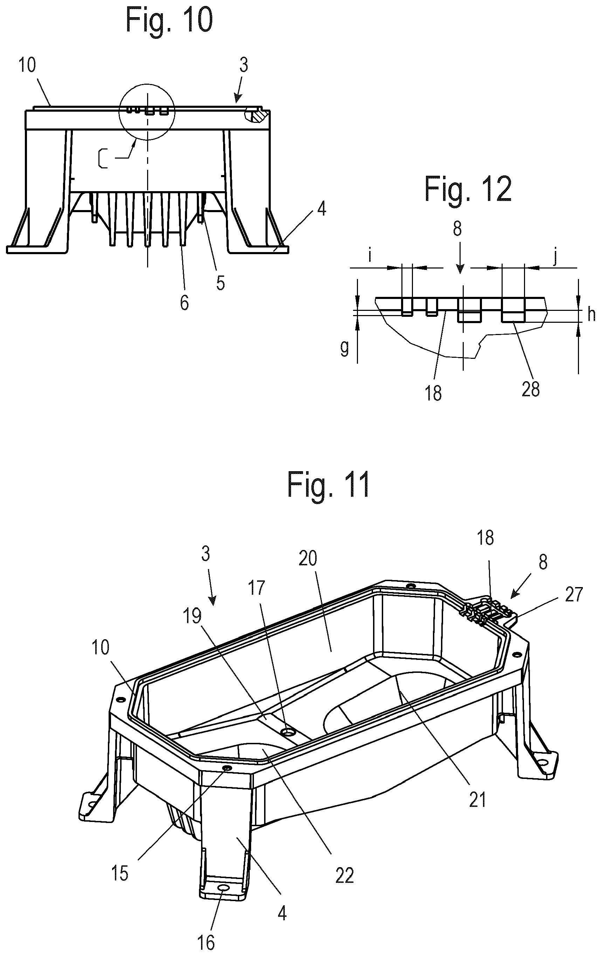

In **Fig. 5-11** sind weitere Details des Gehäuseunterteils 3 dargestellt. So sind u.a. Löcher 16 in den Montagefüßen 4 erkennbar, durch welche ein mechanisches Verbindungsmittel, z.B. eine Schraube geführt werden kann, um das Elektronikgehäuse 1 mit dem Fahrzeug 200 zu verbinden.

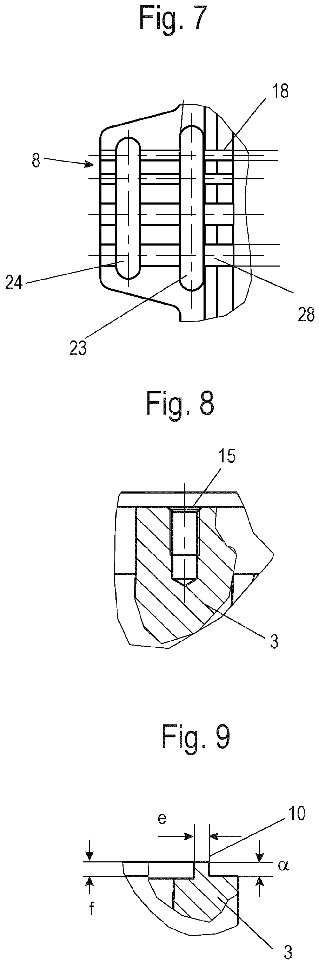

Weiterhin weist die Leitungsführung 8 eine randseitigen Leitungsauflage 27 auf, welche eine Oberfläche auf der gleichen Ebene wie die Dichtfläche 14 oder zumindest parallel dazu aufweist. Weiter in **Fig. 5** und **Fig. 8** sind die Verbindungsstellen 15 als Schraubkanäle dargestellt, welche senkrecht zur umlaufenden Dichtfläche 14 in die Wandung des Gehäuseunterteils 3 hineinragen. Die Tiefe der Schraubkanäle kann vorzugsweise zumindest 2 % der Höhe h des Gehäuseunterteils 3 betragen.

In der Draufsicht der **Fig. 6** ist die Innenanordnung des Gehäuseunterteils 2 erkennbar. Das Gehäuseunterteil 2 weist zwei bodenseitige Auswölbungen 21 und 22 aus zwischen welchen ein Steg 19 angeordnet ist. Der Steg 19 erstreckt sich über weniger als als 50%, vorzugsweise weniger als 25%, der Höhe h des Gehäuseunterteils 3.

Der Steg 19 weist ein Druckausgleichsventil 17 zum Ausgleich von Über- oder insbesondere Unterdruck und/oder ggf. zum Ableiten von Kondenswasser auf.

Die bodenseitigen Auswölbungen 21 und 22 bilden eine Erweiterung des Bauraums des Elektronikgehäuses zur Anordnung von Elektronikbauteilen. Zugleich ermöglichen die Auswölbungen aufgrund der außenseitig an den Auswölbungen 21 und 22 angeordneten Temperaturleitrippenn 5 und 6 eine besonders gute Wärmeableitung.

Von den umgangsseitigen Wandungen des Gehäuseunterteils 2 zu den jeweiligen Auswölbungen 21 und 22 hin weist ein bodenseitige Wandungssegment 20 einen trichterförmigen Verlauf auf, was eine Sebstzentrierung und die Anordnung von Elektronikbauteilen bei deren Einbau erleichtert.

Die Leitungsauflage 27 weist einen Leitungskanal 18 auf, in welchen eine Signal- und/oder Energieleitung einliegt. Der Leitungskanal 18 weist zwei in der Schnittdarstellung nutförmige Kanalerweiterungen 23 und 24 auf. Diese Kanalerweiterungen 23 und 24 dienen der Anordnung eines Dichtmittels, beispielsweise eines Dichtungselements oder eines flüssigen Dichtmittels, analog zur Dichtung 7. Die Kanalerweiterung 23, 24 kann zumindest einen 15% größeren maximalen Durchmesser aufweisen als der Durchmesser des Leitungskanals 18 und kann sich insbesondere auch über alle weiteren Leitungskanäle der Leitungsauflage 27 erstrecken.

Die Kanalerweiterungen 23, 24 sind entlang des Leitungskanals 18 hintereinander angeordnet. Die Leitungsauflage weist insgesamt 4 Leitungskanäle auf, wobei ein zweiter Leitungskanal identisch zum ersten Leitungskanal 18 ausgebildet ist und wobei ein dritter und vierter Leitungskanal 28 einen größeren Kanaldurchmesser j als der Kanaldurchmesser i des ersten Leitungskanals 18 aufweist. Entsprechend sind die Kanalerweiterungen 25 und 26 größer dimensioniert als die Kanalerweiterungen 23 und 24. Die Ausgestaltungen der Leitungskanäle 18 und 28 sind in **Fig. 6****,** **7** **und** **Fig. 12** dargestellt.

In **Fig. 9** ist der Vorsprung 10 dargestellt. Dieser ist vorteilhaft als umlaufende auf dem Gehäuserand ausgebildete Dichtleiste ausgebildet, welche gegenüber der Dichtfläche 14 hervorsteht.

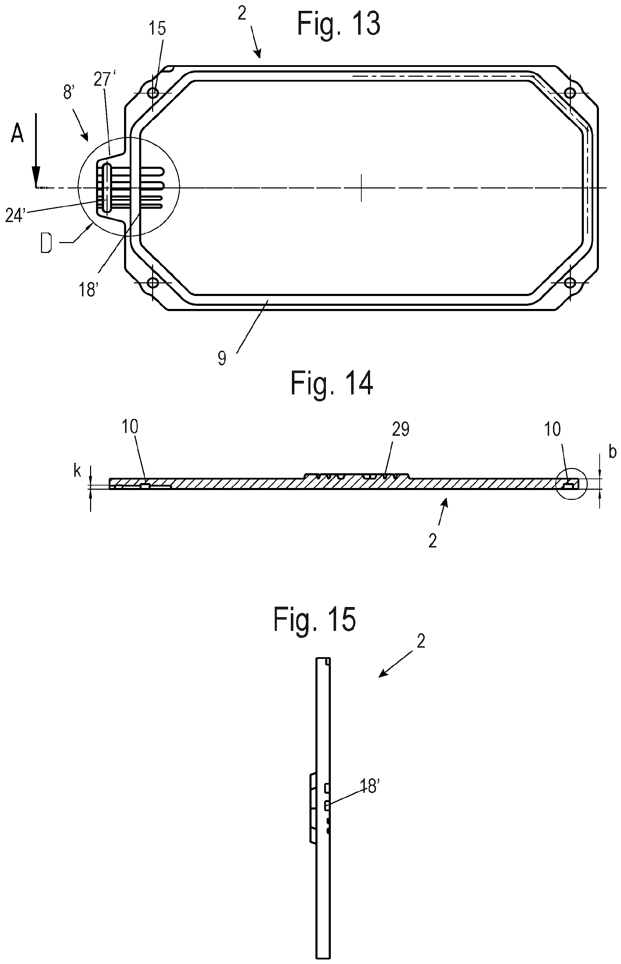

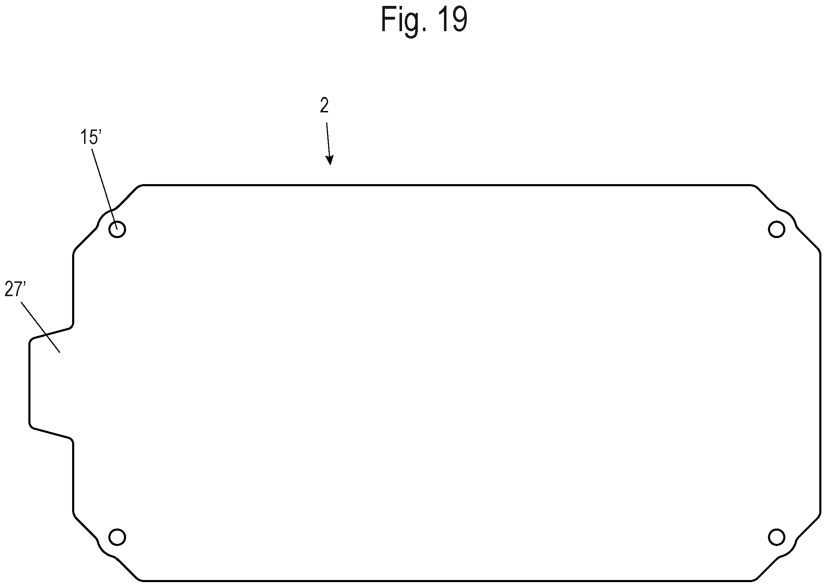

Vorteilhaft kann die Dichtleiste durch die Kabelkanäle 18, 28 oder auch 18' und 28' der Fig. 13-19 unterbrochen sein.

Damit sind die Kabel nicht einem übermäßigen Druck ausgesetzt, so dass die Gefahr der Beschädigung deutlich vermindert ist. Das Gehäuse wird im Außenbereich eines Fahrzeugs eingesetzt. Eine gelegentliche Bewegung der Kabel z.B. durch Fahrtwind ist damit wahrscheinlich. Die Kabel werden durch nur durch den Kabelkanal ggf. mit einem angepassten Durchmesser gehalten.

Um die Dichtheit zu verbessern, sind im Bereich der Kabel einer oder besonders bevorzugt Nuten ― als Kanalerweiterungen 23, 24 - für die fließfähige Dichtung vorgesehen, also bildet die Stelle eine Form einer Doppeldichtung.

Weiterhin vorteilhaft entspricht die mittlere Höhe d des Vorsprungs 10 vorzugsweise zumindest 50 %, vorzugsweise zumindest 70% der mittleren Nuttiefe a der Nut 9. Die Breite e des Vorsprungs 10 entspricht vorzugsweise zumindest 25%, besonders bevorzugt 30-70%, der mittleren Nutbreite c der Nut 9.

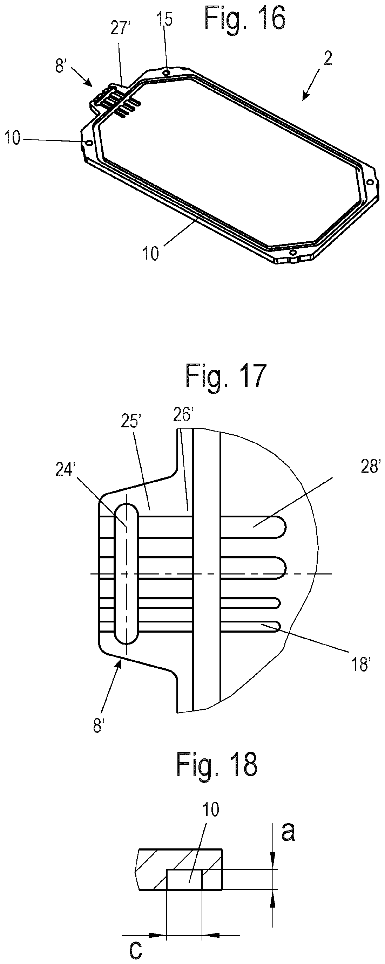

In **Fig. 13-19** sind weitere Details des Deckels 2 des Elektronikgehäuses 1 dargestellt. Der Deckel 2 weist einen im Bereich der Leitungsführung 7 eine Leitungsabdeckung 27' auf mit Leitungskanälen 18' und 28' und Kanalerweiterungen 23', 24', 25', und 26' auf, welche mit der Ausgestaltung der Leitungsauflage 27 korrespondieren. Diese ist im Detail in Fig. 17 dargestellt. Weiterhin ist die Nut 9 im Detail in Fig. 18 dargestellt.

Die Deckeloberfläche kann eine eingravierte Beschriftung oder Gravierung 29 aufweisen

Dabei sind die Nuten 23 und 24 sind vorzugsweise nach außen hin verschlossen, so dass kein Dichtmittel entweichen kann. Der Verlauf der Nuten ist schräg, vorzugsweise senkrecht, zu den Leitungskanälen 18 und 28.

### BEZUGSZEICHENLISTE

- 1: Elektronikgehäuse
- 2: Deckel
- 3: Gehäuseunterteil
- 4: Montagefüße
- 5: Temperaturleitrippe
- 6: Temperaturleitrippe
- 7: Dichtung
- 8: Leitungsführung
- 9: Nut
- 10: Vorsprung
- 11: Freiraum
- 12: Auflagestelle
- 13: Schlitz
- 14: Dichtfläche
- 15: Verbindungsstellen
- 16: Löcher
- 17: Druckausgleichsventil
- 18: Leitungskanal
- 19: Steg
- 20: bodenseitiges Wandsegment
- 21: Auswölbung
- 22: Auswölbung
- 23: Kanalerweiterung
- 24: Kanalerweiterung

- 27: Leitungsauflage
- 28: Leitungskanal
- 29: Gravierung

- 18': Leitungskanal
- 23': Kanalerweiterung
- 24': Kanalerweiterung

- 27': Leitungsabdeckung
- 28': Leitungskanal

- a: Nuttiefe
- b: Deckelhöhe
- c: Nutbreite
- d: Vorsprungshöhe
- e: Vorsprungsbreite
- h: Höhe Gehäuseunterteil

- 100: Abbiegeassistenzsystem
- 101: Sensorelement
- 102: Elektronikkomponenten
- 103: Signalleitung
- 104: weitere Sensoren

- 200: Fahrzeug

## Patentansprüche

1. Abbiegeassistenzsystem (100) eines Fahrzeugs (200) umfassend ein Elektronikgehäuse (1) umfassend ein Gehäuseunterteil (3) für die Anordnung einer oder mehrerer Elektronikkomponenten des Abbiegeassistenzsystems (100) und einen Deckel (2) zum Verschluss des Innenraums des Elektronikgehäuses (1), **dadurch gekennzeichent, dass** das Elektronikgehäuse (1) eine umlaufende Labyrinthdichtung (7) zwischen dem Deckel (2) und dem Gehäuseunterteils (3) aufweist.

2. Abbiegeassistenzsystem nach Anspruch 1, **dadurch gekennzeichnet, dass** der Deckel (2) mittels mechanischer Mittel mit dem Gehäuseunterteil (3) verbunden ist, wobei der Deckel (2) lösbar durch Lösen der mechanischen Mittel mit dem Gehäuseunterteil (3) verbunden ist.

3. Abbiegeassistenzsystem nach Anspruch 1 oder 2, **dadurch gekennzeichnet, dass** das Elektronikgehäuse (1) eine randseitige Leitungsführung (7) mit Leitungskanälen (18, 28) zur Anordnung von Signalleitungen und/oder Energieleitungen aufweist.

4. Abbiegeassistenzsystem nach einem der vorhergehenden Ansprüche, **dadurch gekennzeichnet, dass** die Labyrinthdichtung (7) zumindest eine Nut (9) und einen in die Nut (9) hineinragenden umlaufenden Vorsprung (10) aufweist, wobei zwischen der Nut (9) und dem Vorsprung (10) ein Freiraum (11) zur Aufnahme eines Dichtmittels, insbesondere eines fließfähigen Dichtmediums, angeordnet ist.

5. Abbiegeassistenz nach den vorhergehenden Ansprüchen 3 und 4, **dadurch gekennzeichnet, dass** der umlaufende Vorsprung (10) als eine umlaufende Dichtleiste ausbildet, welche durch die Leitungskanäle (18, 28, 18', 28') unterbrochen ist.

6. Abbiegeassistenzsystem nach einem der vorhergehenden Ansprüche, **dadurch gekennzeichnet, dass** die Labyrinthdichtung (7) randseitig, insbesondere in Richtung der Außenseite des Elektronikgehäuses (1), eine Dichtfläche (14) aufweist, entlang welcher der Deckel (2) und das Gehäuseunterteil (3) aneinander anliegen.

7. Abbiegeassistenzsystem nach einem der vorhergehenden Ansprüche, **dadurch gekennzeichnet, dass** die Labyrithdichtung (7) randseitig, insbesondere in Richtung des Innenraumes des Elektronikgehäuses (1), einen umlaufenden Schlitz (13) als Ausgleichsbereich für das Dichtmittel aufweist.

8. Abbiegeassistenzsystem nach einem der vorhergehenden Ansprüche, **dadurch gekennzeichnet, dass** die Leitungskanäle (18, 28, 18', 28') zumindest eine oder mehrere nutförmige Kanalerweiterungen (23, 24, 24'), insbesondere eine oder mehrere nutförmige Ausfräsungen, vorzugsweise zur Aufnahme von Dichtmittel, aufweisen.

9. Abbiegeassistenzsystem nach einem der vorhergehenden Ansprüche, **dadurch gekennzeichnet, dass** die Labyrithdichtung und/oder die Kanalerweiterungen (23, 24, 24'), insbesondere umlaufend um das Gehäuse, mit dem Dichtmittel versehen ist, wobei das Dichtmittel ein fließfähiges nicht-aushärtbares Dichtmittel, insbesondere ein flüssiges oder pastöses Dichtmittel und/oder ein Dichtmittel auf Silikonbasis, ist.

10. Abbiegeassistenzsystem nach einem der vorhergehenden Ansprüche, **dadurch gekennzeichnet, dass** die Leitungsführung (7) eine Leitungsauflage (27) und eine Leitungsabdeckung (27') umfasst, wobei die Leitungsauflage (27) und/oder Leitungsabdeckung (27') jeweils zumindest einen oder mehreren Leitungskanal (18, 28, 18', 28) und pro Leitungskanal (18, 28, 18', 28') zumindest einen, vorzugsweise zwei, nacheinander angeordnete Kanalerweiterungen (23 24, 24') aufweisen.

11. Abbiegeassistenzsystem nach einem der vorhergehenden Ansprüche, **dadurch gekennzeichnet, dass** die Leitungsauflage (27) und die Leitungsabdeckung (27') aufeinander in Wesentlichen auf der gleichen Ebene wie die Dichtfläche (14) aufliegen.

12. Abbiegeassistenzsystem nach einem der vorhergehenden Ansprüche, **dadurch gekennzeichnet, dass** das Elektronikgehäuse (1) Temperaturleitrippen (5, 6) aufweist und dass das Elektronikgehäuse (1) als ein Aluminiumgehäuse ausgebildet ist.

13. Abbiegeassistenzsystem nach Anspruch 12, **dadurch gekennzeichnet, dass** das Elekronikgehäuse (1) zumindest eine bodenseitige Auswölbung (21, 22) aufweist, entlang welcher die Temperaturleitrippen (5, 6) außenseitig angeordnet sind.

14. Abbiegeassistenzsystem nach einem der vorhergehenden Ansprüche, **dadurch gekennzeichnet, dass** das Elektronikgehäuse (1), isnbesondere der Steg (19) ein Druckausgleichsventil (17) aufweist.

15. Abbiegeassistenzsystem nach einem der vorhergehenden Ansprüche, **dadurch gekennzeichnet, dass** das Elektronikgehäuse (1) eines oder mehrere Elektronikbauteile aufweist, welche vermittels einer Wärmeleitpaste an der Innenseite der Auswölbungen (21, 22) angeordnet sind.

16. Abbiegeassistenzsystem nach einem der vorhergehenden Ansprüche, **dadurch gekennzeichnet, dass** das Abbiegeassistenzsystem (100) eines oder mehrere Sensorelemente, vorzugsweise zumindest eine Kamera, besonders bevorzugt zumindest eine Weitwinkelkamera, aufweist, welche außerhalb des Elektronikgehäuses (1) angeordent sind.

17. Fahrzeug umfassend ein Abbiegeassistenzsystem nach einem der vorhergehenden Ansprüche.
